# EUROPEAN PATENT APPLICATION

(11) **EP 4 836 598 A1**
(43) Date of publication of application: **04.11.2026**
(21) Application number: 25226469.2
(22) Date of filing: 22.12.2025
(51) Int. Cl.: H05K 1/11, H05K 3/32, H01M 10/42, H01M 50/528

(54) **PROTECTION CIRCUIT MODULE AND BATTERY PACK**

(30) Priority: 02.05.2025 KR 20250057962
(71) Applicant: SAMSUNG SDI CO., LTD., Yongin-si, Gyeonggi-do 17084 (KR)
(72) Inventor: WANG, Han Jun, 16678 SUWON-SI (KR); LEE, Ho Geun, 16678 SUWON-SI (KR)
(74) Representative: Regimbeau

(57) **Abstract**

A protection circuit module (200) includes a connection member (220) including a first connection area (220a) and a second connection area (220b), and a circuit board (210) including, on one surface facing the connection member, a bonding part (213) that is soldered in the first connection area of the connection member and a groove part (215) that is formed to have a step with the one surface at a location corresponding to a gap between the first connection area (220a) and the second connection area (220b).

## Description

### TECHNICAL FIELD

The present disclosure relates to a protection circuit module and a battery pack.

### TECHNICAL BACKGROUND

In general, with the rapid spread of electronic devices that use batteries, such as portable phones, laptop computers, and electric vehicles, the demand for secondary batteries with high energy density and high capacity is rapidly increasing. Accordingly, research and development to improve the performance of lithium secondary batteries is actively being conducted.

A lithium secondary battery is a battery that includes a positive electrode and a negative electrode including active materials capable of intercalation and deintercalation of lithium ions, and an electrolyte, and produces electrical energy through oxidation and reduction reactions when lithium ions are intercalated/deintercalated into/from the positive electrode and negative electrode.

The above-described information disclosed in the background technology of this invention is only intended to improve understanding of the background of the present disclosure and therefore may include information that does not constitute related art.

### SUMMARY

Aspects of the present disclosure are directed to a protection circuit module capable of preventing a flux from being introduced into a gap between a circuit board and a connection member during the welding of a secondary battery and a protection circuit module, and a battery pack including the protection circuit module.

However, technical problems to be solved by the present disclosure are not limited to the problems described above, and other problems that are not described may be clearly understood by those skilled in the art from the description of the disclosure described below.

The disclosure relates to a protection circuit module and a battery pack as defined in the appended claims.

According to some embodiments of the present disclosure, there is provided a protection circuit module including: a connection member including a first connection area and a second connection area; and a circuit board including, on one surface facing the connection member, a bonding part that is soldered in the first connection area of the connection member and a groove part that is formed to have a step with the one surface at a location corresponding to a gap between the first connection area and the second connection area.

In some embodiments, the circuit board further includes a protection part provided at a location corresponding to the second connection area, and the groove part is formed between the bonding part and the protection part.

In some embodiments, the bonding part is on each of both sides of the protection part, and the groove part is formed to surround an edge of the protection part adjacent to the bonding part.

In some embodiments, the groove part has a width of 0.5 mm or more.

In some embodiments, the circuit board further includes a plurality of metal layers and one or more insulating layers between the plurality of metal layers that are adjacent to each other, and the bonding part and the protection part are parts of a first metal layer of the plurality of metal layers that is closest to the connection member.

In some embodiments, the groove part has a depth that exposes one surface of any one insulating layer of the one or more insulating layers.

In some embodiments, the groove part has a depth that exposes one surface of an insulating layer of the one or more insulating layers that is in contact with the first metal layer.

In some embodiments, the bonding part is on each of both sides of the second connection area, and the groove part is formed in an entire space between the bonding parts on both sides.

In some embodiments, the protection circuit module is electrically connected to one or more secondary batteries, and the connection member is bonded to an electrode tab of the secondary battery in the second connection area.

In some embodiments, the connection member includes: a lower plate located between the circuit board and the electrode tab; an upper plate located above the lower plate with the electrode tab therebetween; and a hinge portion connecting one side of the lower plate and one side of the upper plate.

In some embodiments, the upper plate, the electrode tab, and the lower plate are bonded by welding in the second connection area.

According to some embodiments of the present disclosure, there is provided a battery pack including: one or more secondary batteries including an electrode tab extending outward; and a protection circuit module including a circuit board and a connection member located between the circuit board and the electrode tab and electrically connected to the one or more secondary battery, wherein the connection member has a first connection area soldered to the circuit board and a second connection area bonded to the electrode tab, and wherein the circuit board includes, on one surface facing the connection member, a bonding part that is soldered in the first connection area of the connection member and a groove part that is formed to have a step with the one surface at a location corresponding to a gap between the first connection area and the second connection area.

In some embodiments, the circuit board further includes a protection part provided at a location corresponding to the second connection area, and the groove part is formed between the bonding part and the protection part.

In some embodiments, the bonding part is on each of both sides of the protection part, and the groove part is formed to surround an edge of the protection part that is adjacent to the bonding part.

In some embodiments, the groove part has a width of 0.5 mm or more.

In some embodiments, the circuit board further includes a plurality of metal layers and one or more insulating layers between the plurality of metal layers that are adjacent to each other, and the bonding part and the protection part are parts of a first metal layer of the plurality of metal layers that is closest to the connection member.

In some embodiments, the groove part has a depth that exposes one surface of any one insulating layer of the one or more insulating layers.

In some embodiments, the groove part has a depth that exposes one surface of an insulating layer of the one or more insulating layers that is in contact with the first metal layer.

In some embodiments, the bonding part is on each of both sides of the second connection area, and the groove part is formed in an entire space between the bonding parts on both sides.

In some embodiments, the connection member includes: a lower plate located between the circuit board and the electrode tab; an upper plate located above the lower plate with the electrode tab therebetween; and a hinge portion connecting one side of the lower plate and one side of the upper plate, and the upper plate, the electrode tab, and the lower plate are bonded by welding in the second connection area.

### BRIEF DESCRIPTION OF THE DRAWINGS

The following drawings attached to the present specification illustrate exemplary embodiments of the present invention and further describe aspects and features of the present invention together with the detailed description of the present invention. Thus, the present invention should not be construed as being limited to the drawings, in which:
FIG. 1 is a perspective view schematically showing a configuration of a battery pack according to some embodiments of the present disclosure;
FIG. 2 is an exploded perspective view schematically showing a configuration of a secondary battery according to some embodiments of the present disclosure;
FIG. 3 is an exploded perspective view schematically showing a part of a protection circuit module according to some embodiments of the present disclosure;
FIG. 4 is a view schematically showing a configuration in a state where the protection circuit module and the secondary battery are bonded to each other, and is a state before a connection member is folded, according to some embodiments of the present disclosure;
FIG. 5 is a view schematically showing a configuration in a state where the protection circuit module and the secondary battery are bonded to each other, and is a state after the connection member is folded, according to some embodiments of the present disclosure;
FIG. 6 is an enlarged view of portion VI of FIG. 3, according to some embodiments of the present disclosure;
FIG. 7 is a cross-sectional view taken along the line VII-VII in FIG. 6, according to some embodiments of the present disclosure;
FIG. 8 is a cross-sectional view additionally showing a state in which a connection member and a tab are bonded to an upper surface of the circuit board of FIG. 7, according to some embodiments of the present disclosure;
FIG. 9 is a cross-sectional view schematically showing a part of a configuration of a protection circuit module according to some other embodiments of the present disclosure; and
FIG. 10 is a cross-sectional view schematically showing a part of a configuration of a protection circuit module according to still other embodiments of the present disclosure.

### DETAILED DESCRIPTION

Hereinafter, exemplary embodiments of the present disclosure will be described in detail with reference to the attached drawings. Prior to this, terms or words used in this specification and claims should not be interpreted as being limited to ordinary or dictionary meanings and should be interpreted as meanings and concepts consistent with the technical idea of this invention based on the principle that the inventor can properly define the concept of the term in order to describe his or her invention in the best way. Accordingly, it is to be understood that the embodiments described herein, and the configurations illustrated in the drawings are only some of the most exemplary embodiments of the invention and do not represent all of the technical ideas of the disclosure, and that there may be various equivalents and modifications that may replace them at the time of filing.

Furthermore, when used herein, the terms "comprise or include" and/or "comprising or including" specify the presence of the mentioned shapes, numbers, steps, operations, members, elements, and/or groups thereof and are not intended to exclude the presence or addition of one or more other shapes, numbers, operations, members, elements, and/or groups thereof.

In addition, in order to help understand the invention, the attached drawings are not drawn to actual scale, and the dimensions of some components may be exaggerated. In addition, the same reference numbers may be assigned to the same components in different embodiments.

The statement that two objects for comparison are "equal" means "substantially the same." Therefore, substantially the same may include deviations that are considered low in the art, for example, deviations of less than 5%. Additionally, uniformity of a parameter over a given region may mean uniformity from an average perspective.

Although first, second, and the like are used to describe various components, the components are not limited by these terms. These terms are used only to distinguish one component from another, and unless otherwise specifically stated, it is to be understood that a first component may also be a second component.

Throughout the specification, unless otherwise specifically stated, each element may be singular or plural.

When an arbitrary configuration is disposed "on (or under)" a component or "above (or below)" a component, it can mean not only that the arbitrary configuration is disposed in contact with the top (or bottom) of the component, but also that other configurations can be interposed between the component and the arbitrary configuration disposed on (or under) the component.

In addition, when a component is described as being "on," "connected to," or "coupled to" another component, the above components may be directly connected or coupled to each other, but it should be understood that other components may be "interposed" between each component, or each component may be "connected," "coupled," or "linked" through another component.

As used herein, the term "and/or" includes any and all combinations of one or more of the associated listed items. For example, the expression "A and/or B" denotes A, B, or A and B. Expressions such as "one or more of" and "at least one of," when preceding a list of elements, modify the entire list of elements and do not modify the individual elements of the list. For example, the expression "one or more of A, B, and C," "at least one of A, B, or C," "at least one of A, B, and C," and "at least one selected from the group consisting of A, B, and C" indicates only A, only B, only C, both A and B, both A and C, both B and C, or all of A, B, and C.

The term "use" may be considered synonymous with the term "utilize." As used in the present specification, the terms "substantially," "about," and other similar terms are used as terms of approximation rather than terms of degree, and are intended to consider an inherent variation in measured or calculated values recognized by those skilled in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be named a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the drawings. It will be understood that the spatially relative terms are intended to encompass different orientations of the device in use or operation in addition to the orientation depicted in the drawings. For example, when the elements or features in the drawings are inverted, an element described as "lower" or "below" "becomes "upper" or "above." Therefore, the term "below" can encompass both the upward and downward directions.

The terms used in the present specification are intended to describe the embodiments of the present invention, and are not intended to limit the present invention.

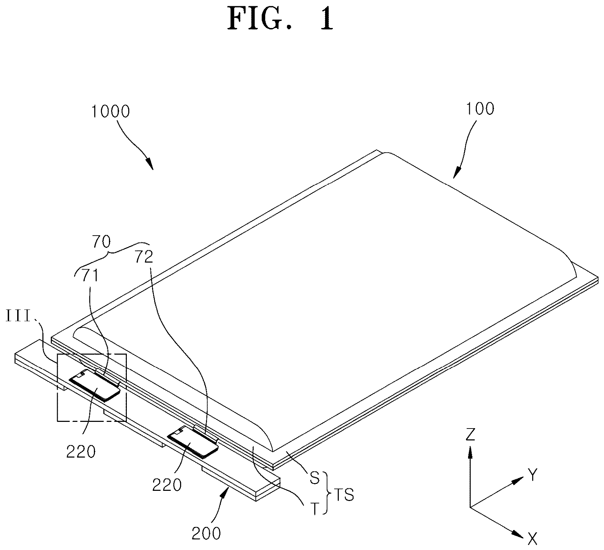

FIG. 1 is a perspective view schematically showing a configuration of a battery pack according to some embodiments of the present disclosure. Referring to FIG. 1, a battery pack 1000 according to some embodiments of the present disclosure includes one or more secondary batteries 100 and a protection circuit module 200.

Although FIG. 1 shows a configuration in which one secondary battery 100 is electrically connected to the protection circuit module 200, embodiments of the present disclosure are not limited thereto. For example, the battery pack 1000 may include one protection circuit module 200 and two or more secondary batteries 100 connected to the one protection circuit module 200. In some examples, the battery pack 1000 may include a plurality of protection circuit modules 200 and one or more secondary batteries 100 connected to each of the plurality of protection circuit modules 200.

The secondary battery 100 may function as a unit structure for storing and supplying power in the battery pack 1000.

The protection circuit module 200 may form a path of a high current such as a charge/discharge current of the secondary battery 100 or may form a path of a low current related to state information of the secondary battery 100. The protection circuit module 200 may obtain state information such as temperature, voltage, and current as the state information of the secondary battery 100. Based on the obtained state information, the protection circuit module 200 may protect the secondary battery 100 in response to an abnormal situation of the secondary battery 100 and take appropriate protection measures in preparation for an accident such as an explosion or an ignition of the secondary battery 100. For example, the protection circuit module 200 may stop charging/discharging of the secondary battery 100 by controlling a switch device formed on a charging/discharging path.

The secondary battery 100 forming an electrical connection with the protection circuit module 200 may be disposed (e.g., positioned/located/arranged) near the protection circuit module 200. One or two or more secondary batteries 100 forming an electrical connection with the protection circuit module 200 may be disposed near the protection circuit module 200. FIG. 1 shows a configuration where only one secondary battery 100 is disposed near the protection circuit module 200, but this is merely exemplary.

When a plurality of secondary batteries 100 are disposed near the protection circuit module 200, the secondary batteries 100 may be disposed at adjacent locations so that electrode tabs 70 extend parallel to each other. The protection circuit module 200 may have a sufficiently large size to be connected to each of the electrode tabs 70 of the plurality of secondary batteries 100. At least two or more secondary batteries 100 forming an electrical connection with the protection circuit module 200 may be disposed near the protection circuit module 200. For example, a plurality of secondary batteries 100 may be disposed on one side of the protection circuit module 200 so that the electrode tabs 70 extend parallel to each other, or a plurality of secondary batteries 100 may be disposed on both sides of the protection circuit module 200 so that the electrode tabs 70 face each other with the protection circuit module 200 interposed therebetween.

The protection circuit module 200 may be disposed to face a terrace part T from which the electrode tab 70 of the secondary battery 100 is drawn out. The secondary battery 100 disposed to face the protection circuit module 200 may be electrically connected to the protection circuit module 200 through a minimum path through the electrode tab 70.

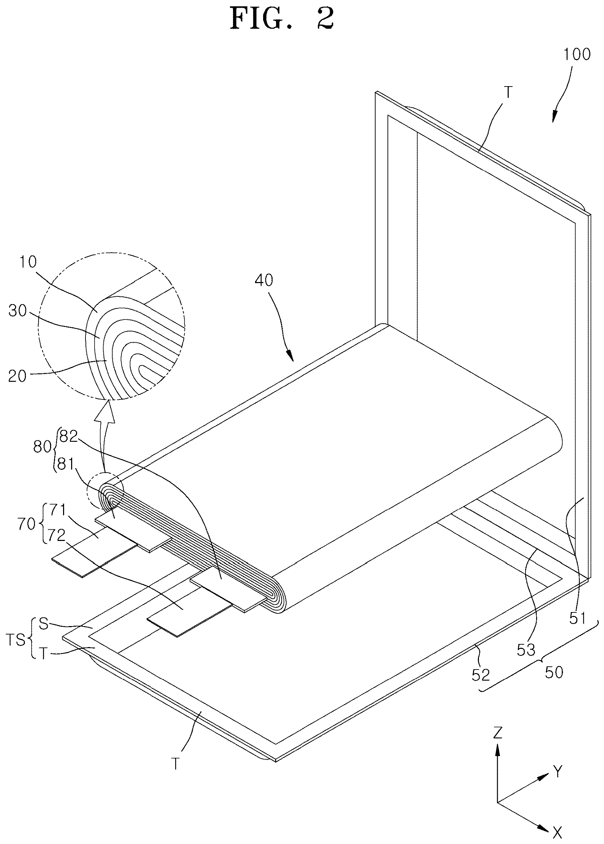

FIG. 2 is an exploded perspective view schematically showing a configuration of a secondary battery according to some embodiments of the present disclosure. Referring to FIG. 2, the secondary battery 100 includes the electrode tab 70 extending outward. The secondary battery 100 may further include an electrode assembly 40 and a case 50 to which the electrode tab 70 is connected.

The electrode assembly 40 may function as a unit structure which performs charging and discharging operations in the secondary battery 100. The electrode assembly 40 may be accommodated in the case 50.

The electrode assembly 40 includes a first electrode 10 and a second electrode 20. The first electrode 10 is a positive electrode or negative electrode. The second electrode 20 is a negative electrode or positive electrode and has a different polarity from the first electrode 10. Hereinafter, an example in which the first electrode 10 is a positive electrode and the second electrode 20 is a negative electrode may be described.

The electrode assembly 40 may further include a separator 30 located between the first electrode 10 and the second electrode 20. The separator 30 may prevent the first electrode 10 and the second electrode 20 from coming into contact with each other and may prevent a short circuit between the first electrode 10 and the second electrode 20. The electrode assembly 40 may be formed by stacking the first electrode 10, the second electrode 20, and the separator 30 provided between the first electrode 10 and the second electrode 20.

A detailed description of each component of the electrode assembly 40 is as follows.

As the positive electrode active material, a compound (e.g., lithiated intercalation compound) capable of reversible intercalation and deintercalation of lithium may be used. For example, at least one of composite oxides of lithium and a metal selected from cobalt, manganese, nickel, and a combination thereof may be used.

The composite oxide may be a lithium transition metal composite oxide, and specific examples thereof may include lithium nickel-based oxides, lithium cobalt-based oxides, lithium manganese-based oxides, lithium iron phosphate-based compounds, cobalt-free nickel-manganese-based oxides, or a combination thereof.

For example, a compound represented as any one of chemical formulas below may be used: LiₐA_{1-b}X_{b}O_{2-c}D_{c} (0.90≤a≤1.8, 0≤b≤50.5, 0≤c≤0.05); LiₐMn_{2-b}X_{b}O_{4-c}D_{c} (0.90≤a≤1.8, 0≤b≤0.5, 0≤c≤0.05); LiₐNi_{1-b-c}Co_{b}X_{c}O_{2-α}D_{α} (0.90≤a≤1.8, 0≤b≤0.5, 0≤c≤0.5, 0<α<2); LiₐNi_{1-b-c}Mn_{b}X_{c}O_{2-α}D_{α} (0.90≤a≤1.8, 0≤b≤0.5, 0≤c≤0.5, 0<α<2); LiₐNi_{b}Co_{c}L¹_{d}GₑO₂ (0.90≤a≤1.8, 0≤b≤0.9, O≤c≤0.5, 0≤d≤0.5, 0≤e≤0.1); LiₐNiG_{b}O₂ (0.90≤a≤1.8, 0.001≤b≤0.1); LiₐCoG_{b}O₂ (0.90≤a≤1.8, 0.001≤b≤0.1); LiₐMn_{1-b}G_{b}O₂ (0.90≤a≤1.8, 0.001≤b≤0.1); LiₐMn₂G_{b}O₄ (0.90≤a≤1.8, 0.001≤b≤0.1); LiₐMn_{1-g}G_{g}PO₄ (0.90≤a≤1.8, 0≤g≤0.5); Li_{(3-f)}Fe₂(PO₄)₃ (0≤f≤2); and LiₐFePO₄ (0.90≤a≤1.8).

In the above chemical formulas, A is Ni, Co, Mn, or a combination thereof; X is Al, Ni, Co, Mn, Cr, Fe, Mg, Sr, V, a rare earth element, or a combination thereof; D is O, F, S, P, or a combination thereof; G is Al, Cr, Mn, Fe, Mg, La, Ce, Sr, V, or a combination thereof; and L1 is Mn, Al, or a combination thereof.

As an example, the positive electrode active material may be a high nickel-based positive electrode active material with a nickel content of 80 mol% or more, 85 mol% or more, 90 mol% or more, 91 mol% or more, or 94 mol% or more and 99 mol% or less based on 100 mol% of metals excluding lithium in the lithium transition metal composite oxide. The high nickel-based positive electrode active material can realize high capacity and thus may be applied to high capacity, high density lithium batteries.

The positive electrode for the secondary battery 100 may include a positive electrode substrate and a positive electrode mixture layer formed on the positive electrode substrate. The positive electrode mixture layer may include a positive electrode active material, and may further include a binder and/or a conductive material.

As an example, the positive electrode may further include a component that may serve as a sacrificial positive electrode.

The content of the positive electrode active material may be 90 wt% to 99.5 wt% based on 100 wt% of the positive electrode mixture layer, and the content of each of the binder and the conductive material may be 0.5 wt% to 5 wt% based on 100 wt% of the positive electrode mixture layer.

The binder serves to attach particles constituting the positive electrode active material to each other well and also to attach the positive electrode active material to the positive electrode substrate well. Representative examples of the binder may include polyvinyl alcohol, carboxymethylcellulose, hydroxypropyl cellulose, diacetylcellulose, polyvinyl chloride, carboxylated polyvinyl chloride, polyvinyl fluoride, polymers containing ethylene oxide, polyvinylpyrrolidone, polyurethane, polytetrafluoroethylene, polyvinylidene fluoride, polyethylene, polypropylene, styrene-butadiene rubber, (meth)acrylated styrene-butadiene rubber, epoxy resin, (meth)acrylic resin, polyester resin, nylon, and the like, but are not limited thereto.

The conductive material is used to impart conductivity to the electrode, and any material which does not cause a chemical change and is electronically conductive may be used. Examples of the conductive material may include a carbon-based material such as natural graphite, artificial graphite, carbon black, acetylene black, Ketjen black, carbon fibers, carbon nanofibers, or carbon nanotubes; a metal-based material in the form of a metal powder or metal fibers containing copper, nickel, aluminum, silver, etc.; a conductive polymer such as a polyphenylene derivative; or a mixture thereof.

Aluminum (Al) foil may be used as the positive electrode substrate, but the present disclosure is not limited thereto.

The negative electrode active material may include a material capable of reversibly intercalating and deintercalating lithium ions, lithium metal, an alloy of lithium and a metal, a material capable of doping and dedoping lithium, or a transition metal oxide.

The material capable of reversibly intercalating/deintercalating lithium ions may be a carbon-based negative electrode active material, for example, crystalline carbon, amorphous carbon, or a combination thereof. Examples of the crystalline carbon may include graphite such as amorphous, plate-shaped, flaky, spherical, or fibrous natural graphite or artificial graphite, and examples of the amorphous carbon may include soft carbon or hard carbon, mesophase pitch carbide, calcined coke, or the like.

An alloy of lithium and a metal selected from Na, K, Rb, Cs, Fr, Be, Mg, Ca, Sr, Si, Sb, Pb, In, Zn, Ba, Ra, Ge, Al, and Sn may be used as the alloy of lithium and a metal.

A Si-based negative electrode active material or Sn-based negative electrode active material may be used as the material capable of doping and dedoping the lithium. The Si-based negative electrode active material may include silicon, a silicon-carbon composite, SiOₓ (0 < x ≤ 2), an Si-Q alloy (Q is selected from an alkali metal, an alkaline earth metal, a Group 13 element, a Group 14 element (excluding Si), a Group 15 element, a Group 16 element, a transition metal, a rare earth element, and a combination thereof), or a combination thereof. The Sn-based negative electrode active material may be Sn, SnOₓ (0<x≤2), a Sn-based alloy, or a combination thereof.

The silicon-carbon composite may be a composite of silicon and amorphous carbon. According to some embodiments, the silicon-carbon composite may be in the form of silicon particles whose surfaces are coated with amorphous carbon. For example, the silicon-carbon composite may include a secondary particle (e.g., a core) in which silicon primary particles are assembled and an amorphous carbon coating layer (e.g., a shell) located on the surface of the secondary particle. The amorphous carbon may also be located between the silicon primary particles, and for example, the silicon primary particles may be coated with the amorphous carbon. The secondary particle may be dispersed in an amorphous carbon matrix.

The silicon-carbon composite may further include crystalline carbon. For example, the silicon-carbon composite may include a core including crystalline carbon and silicon particles and an amorphous carbon coating layer located on a surface of the core.

The Si-based negative electrode active material or Sn-based negative electrode active material may be used in combination with the carbon-based negative electrode active material.

The negative electrode for the secondary battery 100 may include a negative electrode substrate and a negative electrode mixture layer located on the negative electrode substrate. The negative electrode mixture layer may include a negative electrode active material and may further include a binder and/or a conductive material.

For example, the negative electrode mixture layer may include 90 to 99 wt% of the negative electrode active material, 0.5 to 5 wt% of the binder, and 0 to 5 wt% of the conductive material.

The binder serves to attach particles constituting the negative electrode active material to each other well, and also to attach the negative electrode active material to the negative electrode substrate well. The binder may include a non-aqueous binder, an aqueous binder, a dry binder, or a combination thereof.

The non-aqueous binder may include polyvinyl chloride, carboxylated polyvinyl chloride, polyvinyl fluoride, an ethylene propylene copolymer, polystyrene, polyurethane, polytetrafluoroethylene, polyvinylidene fluoride, polyethylene, polypropylene, polyamideimide, polyimide, or a combination thereof.

The aqueous binder may be selected from styrene-butadiene rubber, (meth)acrylated styrene-butadiene rubber, (meth)acrylonitrile-butadiene rubber, (meth)acrylic rubber, butyl rubber, a fluoroelastomer, polyethylene oxide, polyvinylpyrrolidone, polyepichlorohydrin, polyphosphazene, poly(metha)acrylonitrile, an ethylene propylene diene copolymer, polyvinylpyridine, chlorosulfonated polyethylene, latex, polyester resin, (metha)acrylic resin, phenolic resin, epoxy resin, polyvinyl alcohol, and a combination thereof.

When the aqueous binder is used as the negative electrode binder, a cellulose-based compound capable of imparting viscosity may be further included. This cellulose-based compound may be used by mixing one or more of carboxymethyl cellulose, hydroxypropyl methyl cellulose, methyl cellulose, or alkali metal salts thereof. Na, K, or Li may be used as the alkali metal.

The dry binder is a polymer material capable of being fiberized and may be, for example, polytetrafluoroethylene, polyvinylidene fluoride, a polyvinylidene fluoride-hexafluoropropylene copolymer, polyethylene oxide, or a combination thereof.

The conductive material is used to impart conductivity to the electrode, and any material which does not cause a chemical change and is electronically conductive may be used. Specific examples may include a carbon-based material such as natural graphite, artificial graphite, carbon black, acetylene black, Ketjen black, carbon fibers, carbon nanofibers, or carbon nanotubes; a metal-based material in the form of a metal powder or metal fibers containing copper, nickel, aluminum, silver, etc.; a conductive polymer such as a polyphenylene derivative; or a mixture thereof.

The negative electrode substrate may be selected from copper foil, nickel foil, stainless steel foil, titanium foil, nickel foam, copper foam, a polymer substrate coated with a conductive metal, and a combination thereof.

Depending on the type of secondary battery 100, the separator 30 may be present between the first electrode 10 and the second electrode 20. As the separator, polyethylene, polypropylene, polyvinylidene fluoride, or a multilayer film of two or more layers thereof may be used, and a mixed multilayer film such as a polyethylene/polypropylene two-layer separator, a polyethylene/polypropylene/polyethylene three-layer separator, a polypropylene/polyethylene/polypropylene three-layer separator, or the like may also be used.

The separator 30 may include a porous substrate and a coating layer containing an organic material, an inorganic material, or a combination thereof located on one surface or both surfaces of the porous substrate.

The porous substrate may be a polymer film formed of any one polymer selected from polyolefins such as polyethylene and polypropylene, polyesters such as polyethylene terephthalate and polybutylene terephthalate, polyacetal, polyamide, polyimide, polycarbonate, polyether ketone, polyarylether ketone, polyetherimide, polyamideimide, polybenzimidazole, polyether sulfone, polyphenylene oxide, a cyclic olefin copolymer, polyphenylene sulfide, polyethylene naphthalate, glass fiber, and polytetrafluoroethylene (e.g. Teflon), or a copolymer or mixture of two or more thereof.

The organic material may include a polyvinylidene fluoride-based polymer or a (meth) acryl-based polymer.

The inorganic material may include inorganic particles selected from Al₂O₃, SiO₂, TiO₂, SnO₂, CeO₂, MgO, NiO, CaO, GaO, ZnO, ZrO₂, Y₂O₃, SrTiO₃, BaTiO₃, Mg(OH)₂, boehmite, and a combination thereof, but is not limited thereto.

The organic material and the inorganic material may be present as a mixture in a single coating layer or may be present in a form in which a coating layer including an organic material and a coating layer including an inorganic material are stacked.

The electrolyte for the secondary battery 100 includes a non-aqueous organic solvent and a lithium salt.

The non-aqueous organic solvent acts as a medium through which ions involved in the electrochemical reaction of the battery can move.

The non-aqueous organic solvent may be a carbonate-based solvent, an ester-based solvent, an ether-based solvent, a ketone-based solvent, an alcohol-based solvent, an aprotic solvent, or a combination thereof.

Examples of the carbonate-based solvents may include dimethyl carbonate (DMC), diethyl carbonate (DEC), dipropyl carbonate (DPC), methyl propyl carbonate (MPC), ethyl propyl carbonate (EPC), methyl ethyl carbonate (MEC), ethylene carbonate (EC), propylene carbonate (PC), butylene carbonate (BC), and the like.

Examples of the ester-based solvent may include methyl acetate, ethyl acetate, n-propyl acetate, dimethyl acetate, methyl propionate, ethyl propionate, decanolide, mevalonolactone, valerolactone, caprolactone, and the like.

Examples of the ether-based solvent may include dibutyl ether, tetraglyme, diglyme, dimethoxyethane, 2-methyltetrahydrofuran, 2,5-dimethyltetrahydrofuran, and tetrahydrofuran. In addition, cyclohexanone and the like may be used as the ketone-based solvent. As the alcohol-based solvent, ethyl alcohol, isopropyl alcohol, and the like may be used, and as the aprotic solvent, a nitrile such as R-CN (R is a straight, branched, or ring-shaped hydrocarbon group having 2 to 20 carbon atoms, and may include a double bond, an aromatic ring, or an ether group), an amide such as dimethylformamide, a dioxolane such as 1,3-dioxolane or 1,4-dioxolane, a sulfolane, and the like may be used.

The non-aqueous organic solvent may be used alone or in a mixture of two or more.

In addition, when using the carbonate-based solvent, a cyclic carbonate and a chain carbonate may be mixed and used, and the cyclic carbonate and the chain carbonate may be mixed in a volume ratio of 1:1 to 1:9.

The lithium salt is a substance that is dissolved in the organic solvent and acts as a source of lithium ions within the battery, enabling the basic operation of the lithium battery and promoting the movement of lithium ions between the positive electrode and the negative electrode. Representative examples of the lithium salt may include one or more selected from LiPF₆, LiBF₄, LiSbF₆, LiAsF₆, LiClO₄, LiAlO₂, LiAlCl₄, LiPO₂F₂, LiCl, Lil, LiN(SO₃C₂F₅)₂, Li(FSO₂)₂N (lithium bis(fluorosulfonyl)imide (LiFSI)), LiC₄F₉SO₃, LiN(CₓF₂ₓ₊₁SO₂)(C_{y}F_{2y+1}SO₂) (x and y are integers from 1 to 20), lithium trifluoromethane sulfonate, lithium tetrafluoroethanesulfonate, lithium difluorobis(oxalato)phosphate (LiDFBOB), and lithium bis(oxalato)borate (LiBOB).

As shown in FIG. 2, the electrode assembly 40 may have a form in which a laminate of the first electrode 10, the second electrode 20, and the separator 30 located between the first electrode 10 and the second electrode 20 is wound. In some examples, the electrode assembly 40 may have a stack form in which the first electrode 10, the separator 30, the second electrode 20, and the separator 30 are repeatedly stacked.

The case 50 may be formed of a flexible exterior material such as a pouch or the like. The case 50 may include an insulating layer formed on both surfaces of a thin metal layer such as aluminum and/or the like, and may be formed through a forming process such as drawing or the like.

The case 50 may include a first exterior material part 51 and a second exterior material part 52. The first exterior material part 51 and the second exterior material part 52 may be coupled to face each other with the electrode assembly 40 interposed therebetween. The case 50 may further include a folding part 53 that folds so that the first exterior material part 51 and the second exterior material part 52 overlap each other. The case 50 may be folded in a direction in which the first exterior material part 51 and the second exterior material part 52 face each other with the folding part 53 acting as a folding axis. Accordingly, the electrode assembly 40 may be accommodated in the case 50. However, unlike FIG. 2, the case 50 may not include a separate folding part 53. In such examples, the case 50 may be formed by overlapping the first exterior material part 51 and the second exterior material part 52, which are separated from each other, to face each other.

As the first exterior material part 51 and the second exterior material part 52 overlap to face each other with the electrode assembly 40 interposed therebetween, a sealing part TS for sealing an accommodation part may be formed in the case 50 together with the accommodation part in which the electrode assembly 40 is accommodated. For example, the sealing part TS may be formed along the remaining edges of the case 50 except for an edge of the case 50 where the folding part 53 is formed. The case 50 may form an outer shape of a rectangular parallelepiped including a pair of short side portions facing each other and a pair of long side portions facing each other by combining the first exterior material part 51 and the second exterior material part 52. In addition, the sealing part TS may be continuously formed along the pair of long side portions and the remaining short side portion except for the short side portion where the folding part 53 is formed.

The sealing part TS may include a terrace part T from which the electrode tab 70 electrically connected to the electrode assembly 40 is drawn out and a side sealing part S which is in contact with the terrace part T and extends in a direction crossing the terrace part T. For example, the terrace part T may be formed on one short side portion of the case 50, and the side sealing part S may be formed on the pair of long side portions of the case 50. The terrace part T may seal the case 50 while extending in a direction crossing the electrode tab 70, and the side sealing part S may seal the case 50 while extending in a direction crossing the terrace part T.

The electrode tab 70 may extend from the electrode assembly 40. The electrode tab 70 may be connected to the electrode assembly 40 and may extend to the outside of the case 50.

The electrode tab 70 may include a first electrode tab 71 and a second electrode tab 72. The first electrode tab 71 and the second electrode tab 72 may extend in the same direction from one side of the electrode assembly 40. In some examples, unlike that shown in FIG. 2, the first electrode tab 71 and the second electrode tab 72 may extend in opposite directions from both sides of the electrode assembly 40.

The first electrode tab 71 may be electrically connected to the first electrode 10. The first electrode tab 71 may be formed by extending the substrate of the first electrode 10. For example, the first electrode tab 71 may be formed by extending the positive electrode substrate. In some examples, the first electrode tab 71 may have one side bonded on the substrate of the first electrode 10 and the other side extending from the substrate of the first electrode 10. For example, one side of the first electrode tab 71 may be bonded on the positive electrode substrate, and the other side may extend from the positive electrode substrate.

The second electrode tab 72 may be electrically connected to the second electrode 20. The second electrode tab 72 may be formed by extending the substrate of the second electrode 20. For example, the second electrode tab 72 may be formed by extending the negative electrode substrate. In some examples, the second electrode tab 72 may have one side bonded on the substrate of the second electrode 20 and the other side extending from the substrate of the second electrode 20. For example, one side of the second electrode tab 72 may be bonded on the negative electrode substrate, and the other side may extend from the negative electrode substrate.

The electrode tab 70 may be electrically connected to the electrode assembly 40, and may be drawn out of the terrace part T of the case 50 as described above.

The secondary battery 100 may further include an insulating tape 80. The insulating tape 80 may provide electrical insulation and/or sealing between the electrode tab 70 and the case 50. For example, the insulating tape 80 may include a first insulating tape 81 attached to the first electrode tab 71 and/or a second insulating tape 82 attached to the second electrode tab 72.

For example, the electrode tab 70 may be formed in a substantially plate shape. However, the shape of the electrode tab 70 is not limited thereto, and the electrode tab 70 may be formed in an appropriate shape according to the capacity and/or structure of the secondary battery 100.

The electrode tab 70 may extend from the electrode assembly 40 so that one side may face the protection circuit module 200. One side of the electrode tab 70 may be electrically connected to the protection circuit module 200. Accordingly, the electrode tab 70 may function as a path through which the secondary battery 100 and the protection circuit module 200 are electrically connected.

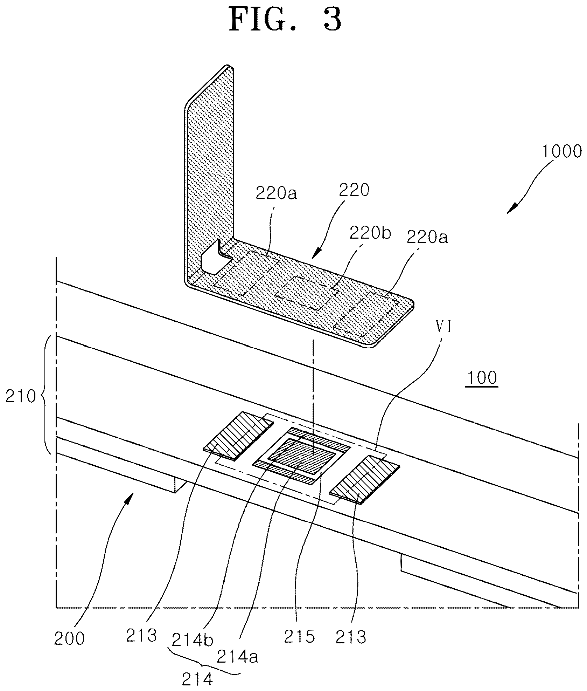

FIG. 3 is an exploded perspective view schematically showing a part of a protection circuit module according to some embodiments of the present disclosure. The exploded perspective view of FIG. 3 may be an example of a part indicated by III of FIG. 1. However, in FIG. 3, in order to more clearly show the configuration of the protection circuit module 200, a view of the electrode tab 70 is omitted. Referring to FIG. 3, the protection circuit module 200 includes a circuit board 210 and a connection member 220.

The circuit board 210 may be bonded to the terminal of the secondary battery 100 to be electrically connected to the secondary battery 100. For example, the circuit board 210 may be electrically connected to the electrode tab 70 of the secondary battery 100. However, the type of terminal bonded to the circuit board 210 is not limited, and the terminal may include a lead tab, a cap plate, a cap assembly, a cap up, and a rivet depending on the shape, size, and/or type of the secondary battery 100. Hereinafter, an example in which the terminal of the secondary battery 100 is the electrode tab 70 will be described.

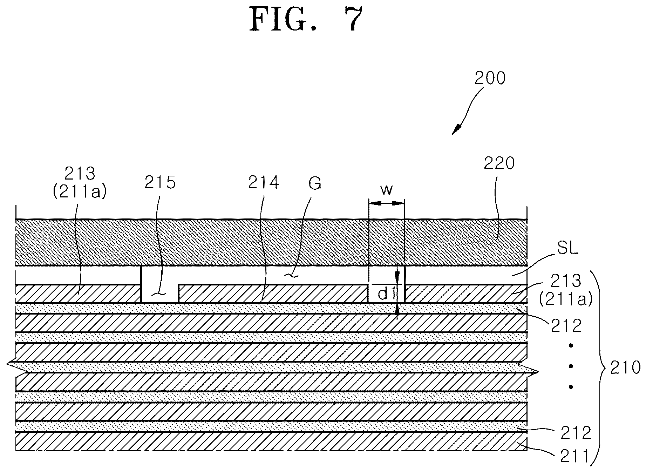

The circuit board 210 may include a board on which a circuit pattern is printed. For example, the circuit board 210 may be formed in a form in which a circuit pattern made of a conductive material is printed on an insulating board. The conductive material may include, for example, a metal such as copper or nickel. As will be described further below with reference to FIG. 7, for example, the circuit board 210 may include a plurality of metal layers 211 on which circuit patterns are formed, and at least one insulating layer 212 disposed between the metal layers 211 that are adjacent to each other.

In the circuit board 210, a bonding surface bonded to the connection member 220, for example, a bonding part 213, may be provided on an upper surface of the circuit board 210 in FIG. 3. The bonding part 213 is for conductive bonding with the connection member 220, and may be formed of a conductive metal material. The bonding part 213 is a part of the circuit pattern and may be a part exposed on the upper surface of the circuit board 210. Accordingly, the connection member 220 and the circuit pattern of the circuit board 210 may be electrically connected through the bonding part 213. A soldering layer SL (see, e.g., FIG. 7) coated with solder cream or the like for soldering with the connection member 220 may be formed on an upper surface of the bonding part 213.

For example, a pair of bonding parts 213 may be provided to be spaced apart at a set or predetermined interval. Accordingly, the bonding part 213 is bonded to the connection member 220 in a first connection area 220a corresponding to both side portions of the connection member 220 having a set or predetermined length, thereby improving the physical and electrical bonding with the connection member 220. Here, the first connection area 220a may refer to an area of the connection member 220 that is bonded to the bonding part 213 by welding or the like. Therefore, in the thickness direction of the circuit board 210, the location of the first connection area 220a may correspond to the location of the bonding part 213.

The connection member 220 may be electrically connected to the circuit pattern of the circuit board 210 by being bonded to the bonding part 213 in the first connection area 220a. The connection member 220 may be bonded and fixed to the bonding part 213 through an intermetallic bonding method such as soldering or the like.

Depending on the implementation, a protection part 214 may be further formed on the bonding surface (e.g., the upper surface) of the circuit board 210. The protection part 214 may perform a function of preventing the circuit board 210 from being damaged during welding of the connection member 220 and the tab 70. The material of the protection part 214 is not particularly limited, and it is sufficient as long as it can protect the circuit pattern of the circuit board 210 by blocking penetration of welding energy. For example, the protection part 214 may also be formed of a metal such as copper or nickel. In such examples, the protection part 214 may be a part of the circuit layer exposed on the upper surface of the circuit board 210. That is, both the protection part 214 and the bonding part 213 are parts of the circuit layer exposed to the upper side of the circuit board 210, and may be separated from each other by a groove part 215 to be described below.

The protection part 214 may be located at a part corresponding to the welding part of the connection member 220 and the electrode tab 70. For example, the protection part 214 may be disposed at a location adjacent to the bonding part 213. As shown in FIG. 3, when the pair of bonding parts 213 are spaced apart from each other at a set or predetermined interval, the protection part 214 may be located between the pair of bonding parts 213.

The connection member 220 may be electrically connected to the electrode tab 70 of the secondary battery 100. For example, the connection member 220 may be electrically connected to the secondary battery 100 by bonding to the electrode tab 70. The connection member 220 may be bonded to the electrode tab 70 in a second connection area 220b. Here, the second connection area 220b may refer to an area of the connection member 220 that is bonded to the electrode tab 70 by welding. Therefore, in the thickness direction of the circuit board 210, the location of the second connection area 220b may correspond to the location of the protection part 214.

The connection member 220 may be provided on the circuit board 210 to be bonded to the bonding part 213 of the circuit board 210 in the first connection area 220a and to be bonded to the electrode tab 70 in the second connection area 220b. For example, when the protection part 214 is located between the pair of bonding parts 213, the connection member 220 may be provided on the circuit board 210 to cover the pair of bonding parts 213 and the protection part 214. In such examples, a pair of first connection areas 220a may be located at both edges of the connection member 220, and the second connection area 220b may be located between the pair of first connection areas 220a.

The connection member 220 may be provided on the circuit board 210 corresponding to the number and/or location of the electrode tabs 70. For example, when one secondary battery 100 includes two electrode tabs 70, two connection members 220 may be provided to bond one secondary battery 100 and the circuit board 210. Furthermore, when the battery pack 1000 includes a plurality of secondary batteries 100, the connection member 220 may be provided in a number corresponding to the number of electrode tabs 70 included in the plurality of secondary batteries 100.

As described above, the circuit board 210 may be electrically connected to and physically bonded to the connection member 220. The circuit board 210 may be bonded to the connection member 220 at the bonding part 213. For example, the circuit board 210 may be bonded to the connection member 220 at the bonding part 213 by soldering. For example, the circuit board 210 may be bonded to the connection member 220 at the bonding part 213 by solder paste including lead (Pb). For example, the circuit board 210 may be bonded to the connection member 220 at the bonding part 213 by solder cream. In some examples, the circuit board 210 may be bonded to the connection member 220 at the bonding part 213 by a solder ball. To this end, the soldering layer SL (see, e.g., FIG. 7) may be additionally formed on the upper surface of the bonding part 213.

When a solder material such as solder paste, solder cream, or a solder ball is applied on the bonding part 213 for soldering to form the soldering layer SL, the flux from the solder material of the soldering layer SL may flow toward the protection part 214 due to the energy applied during the welding process of the connection member 220 and the electrode tab 70. When the flux flows into the upper surface of the circuit board 210, for example, between the protection part 214 and the connection member 220, welding of the connection member 220 and the electrode tab 70 may lead to a defect.

To prevent or alleviate this, the circuit board 210 may further include the groove part 215. The groove part 215 may guide the solder material (e.g., flux) introduced from the soldering layer SL during the welding process between the connection member 220 and the electrode tab 70 to prevent the solder material (e.g., flux) from penetrating into a lower part of the electrode tab 70, for example, an upper surface of the protection part 214, or substantially reduce the likelihood thereof.

To this end, the groove part 215 may be provided to have a step with the upper surface of the circuit board 210 in the flow path of the flux, that is, at least between the bonding part 213 and the protection part 214. As described above, the bonding part 213 is located on the upper surface of the circuit board 210 corresponding to the first connection area 220a of the connection member 220, and the protection part 214 is located on the upper surface of the circuit board 210 corresponding to the second connection area 220b of the connection member 220. Therefore, the groove part 215 may be formed at a corresponding location between the first connection area 220a and the second connection area 220b of the connection member 220 on the circuit board 210. The groove pat 215 may be formed to have a step with the upper surface at a location corresponding to a gap between the first connection area 220a and the second connection area 220b.

In this way, the groove part 215 may be located on one surface of the circuit board 210. The groove part 215 may include a groove having a set or predetermined depth formed to have a step with one surface of the circuit board 210. Because the groove part 215 is disposed between the bonding part 213 and the protection part 214, the flux flowing from the soldering layer SL to the protection part 214 in the welding process of the connection member 220 and the electrode tab 70 may be guided to the groove part 215 and may not reach the protection part 214. Therefore, because the flux does not flow into the upper surface of the protection part 214 or the inflow thereof is suppressed, it is possible to prevent welding defects from occurring during the welding process between the connection member 220 and the electrode tab 70. A specific shape of the groove portion 215 will be described further below.

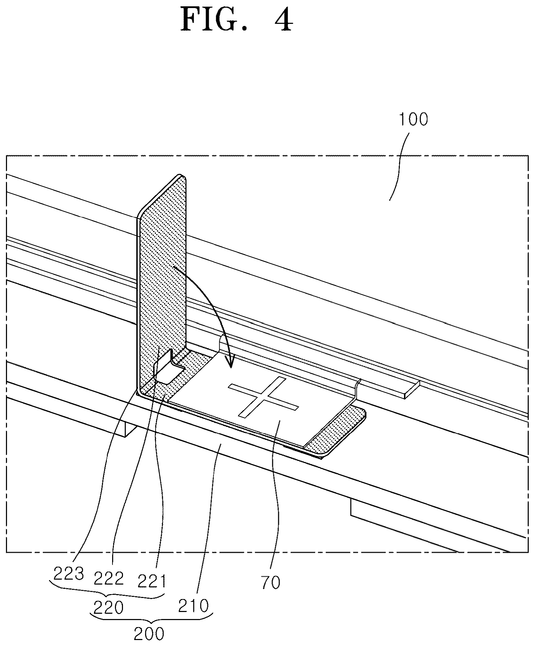

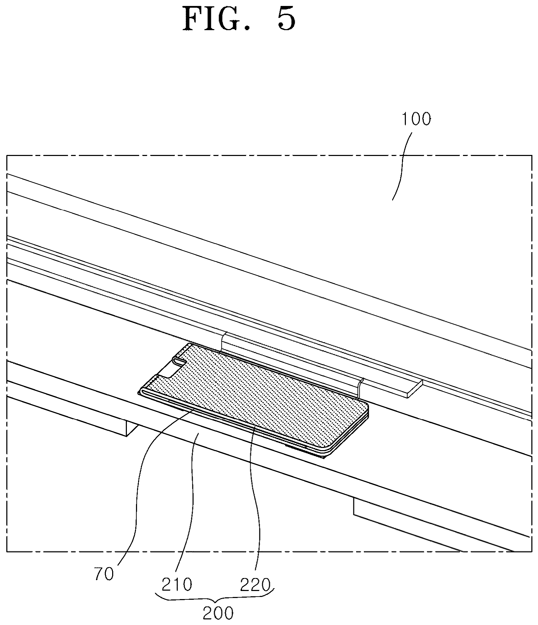

FIGS. 4 and 5 are views schematically showing configurations of a state in which the protection circuit module and the secondary battery are bonded to each other, according to some embodiments of the present disclosure. FIG. 4 is a state in which an upper plate of a connection member is unfolded, and FIG. 5 is a state in which an upper plate of the connection member is folded (e.g., folded down).

Referring to FIGS. 4 and 5, the secondary battery 100 includes the electrode tab 70 extending outward. The secondary battery 100 may include two electrode tabs 70. For example, the secondary battery 100 may include the first electrode tab 71 connected to the first electrode 10 and the second electrode tab 72 connected to the second electrode 20. Although only one of two electrode tabs 70 is shown as an example in FIGS. 4 and 5, the structure according to some embodiments of the present disclosure may be applied to the other electrode tab 70 in the same or similar manner. Thus, in FIGS. 4 and 5, an example in which the electrode tab 70 is the positive electrode tab is shown, however, the same or similar structure may be applied to the negative electrode tab.

As described above, the protection circuit module 200 may include the circuit board 210 and the connection member 220, and may be electrically connected to the secondary battery 100. The bonding part 213 is provided on one surface (e.g., the upper surface) of the circuit board 210, and the connection member 220 may be bonded to the bonding part 213 by soldering or the like. To this end, the soldering layer SL may be provided on the bonding part 213. The bonding part 213 may be provided as a pair and may be spaced apart at a set or predetermined interval.

In addition, the connection member 220 may be bonded to the electrode tab 70 between the pair of bonding parts 213, for example, on the upper side of the protection part 214. For example, the connection member 220 may be disposed on the pair of bonding parts 213 of the circuit board 210. In such examples, the soldering layer SL coated with solder cream or the like for soldering may be provided on the upper surface of the bonding part 213.

Accordingly, the connection member 220 may be in contact with the upper side of the bonding part 213, for example, the soldering layer SL, but may be spaced apart from the protection part 214 with a slight gap. In addition, the electrode tab 70 is disposed on the connection member 220. In addition, when a laser is irradiated onto the electrode tab 70 in a direction toward the connection member 220, the electrode tab 70 may be bonded to the connection member 220.

According to some embodiments, the connection member 220 may include a lower plate 221. The lower plate 221 may be located between the circuit board 210 and the electrode tab 70. For example, when the connection member 220 includes only the lower plate 221, the connection member 220 may be disposed in the order of the electrode tab 70, the lower plate 221, and the circuit board 210 from the top. In such examples, when a laser is irradiated onto the electrode tab 70, the electrode tab 70 may be bonded to the lower plate 221. Accordingly, the connection member 220 may allow the circuit board 210 and the electrode tab 70 to be connected while including only simple components.

According to some other embodiments, the connection member 220 may include a lower plate 221, an upper plate 222, and a hinge portion 223. In such examples, the electrode tab 70 may be disposed between the upper plate 222 and the lower plate 221. That is, the lower plate 221 may be located below the electrode tab 70, and the upper plate 222 may be located above the electrode tab 70.

The hinge portion 223 may connect one side or one edge portion of the lower plate 221 to one side or one edge portion of the upper plate 222. Accordingly, the upper plate 222 may be axially rotated by the hinge portion 223. For example, the connection member 220 may be unfolded by axially rotating the upper plate 222 in a direction away from the lower plate 221 so that the electrode tab 70 may be disposed on the lower plate 221 (see, e.g., FIG. 4). In addition, after the electrode tab 70 is disposed on the lower plate 221, the upper plate 222 is axially rotated in the direction toward the lower plate 221 so that the connection member 220 may be folded (see, e.g., FIG. 5).

As described above, FIG. 5 shows a state in which the upper plate 222 is axially rotated about the hinge portion 223 in a direction toward the lower plate 221 after the electrode tab 70 is provided on the lower plate 221, so that the upper plate 222 covers the electrode tab 70. In such examples, for example, the arrangement may be in the order of the upper plate 222, the electrode tab 70, the lower plate 221, and the circuit board 210 from the top. In such examples, when the laser is irradiated onto the upper plate 222, the electrode tab 70 may be bonded to the lower plate 221 and the upper plate 222.

Through such a structure, the secondary battery 100 may be electrically connected to the protection circuit module 200. In addition, the bonding between the connection member 220 and the electrode tab 70 may be firmly formed, and the electrode tab 70 may be protected from contamination by external impurities or the like.

Next, various embodiments of the groove part 215 provided in the circuit board 210 will be described.

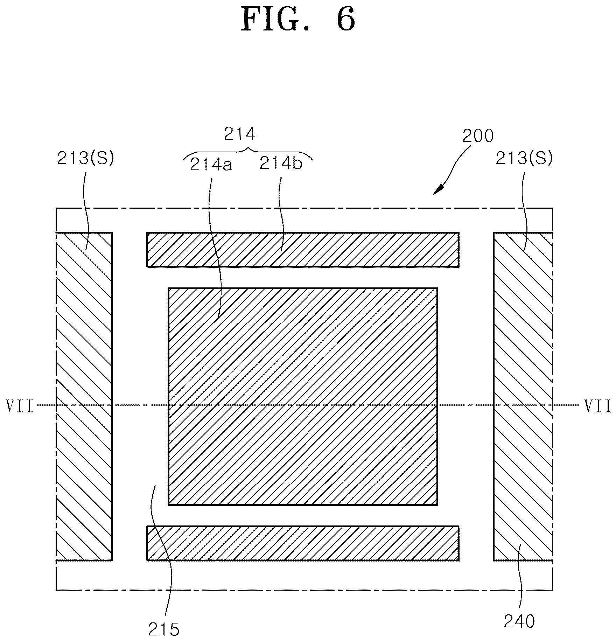

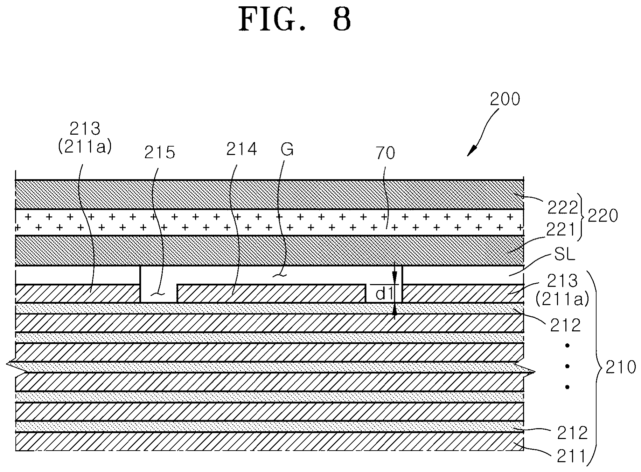

FIG. 6 is an enlarged view of portion VI of FIG. 3, according to some embodiments of the present disclosure. FIG. 7 is a cross-sectional view taken along the line VII-VII in FIG. 6, according to some embodiments of the present disclosure. FIG. 8 is a cross-sectional view additionally showing a state in which a connection member and an electrode tab are bonded to an upper surface of the circuit board of FIG. 7, according to some embodiments of the present disclosure.

Referring to FIGS. 6 to 8, the circuit board 210 includes the bonding part 213 and the protection part 214. The bonding part 213 may be bonded to the connection member 220, thereby electrically connecting the circuit pattern of the circuit board 210 to the connection member 220. In addition, the protection part 214 may serve as a buffer to prevent the circuit board 210 thereunder from being damaged (or substantially reduce the likelihood thereof) when the connection member 220 and the electrode tab 70 are bonded.

The bonding part 213 and the protection part 214 may be parts of the circuit layer exposed on the upper surface of the circuit board 210. Accordingly, the heights of the bonding part 213 and the protection part 214 may be substantially the same. However, the soldering layer SL such as solder cream or a solder ball may be additionally formed on the bonding part 213. Due to the soldering layer SL, a gap G having a set or predetermined size may be present between the protection part 214 and the connection member 220.

The groove part 215 may be formed in the upper surface of the circuit board 210. The groove part 215 may be formed at least between the bonding part 213 and the protection part 214. For example, when the connection member 220 is located on the upper surface of the circuit board 210, the groove part 215 may be formed in the upper surface of the circuit board 210. On the other hand, the connection member 220 may be located on the lower surface of the circuit board 210, and in such examples, the groove part 215 may be formed in the lower surface of the circuit board 210. Hereinafter, examples in which the groove part 215 is formed in the upper surface of the circuit board 210 will be further described.

The groove part 215 may be formed in a part of an upper surface of the circuit board 210. For example, the groove part 215 may be formed in a peripheral area of the protection part 214 and at least between the protection part 214 and the bonding part 213. The groove part 215 may guide the flow of flux flowing from the bonding part 213, for example, from the soldering layer SL, and provide a space that may be filled.

As a result, the flux may not flow into the gap G between the protection part 214 and the connection member 220. That is, the groove part 215 may guide the flow of flux to suppress or block the flux from flowing into the protection part 214. Accordingly, during the bonding process of the connection member 220 and the electrode tab 70, the occurrence of welding defects due to the flux being introduced into the gap G may be suppressed or prevented.

For example, as shown in FIGS. 6 to 8, the groove part 215 may be formed to have a step with the protection part 214 at a location adjacent to the protection part 214 or at the edge of the protection part 214. For example, when the protection part 214 is formed in a substantially rectangular shape as shown in FIG. 6, the groove part 215 may be formed along the edge of the rectangular shape. However, the shapes of the protection part 214 and the groove part 215 are not limited thereto. For example, the protection part 214 may be formed in a substantially circular shape, a substantially oval shape, an irregular shape, or the like, and the groove part 215 may be formed along the edge of the protection part 214. In addition, even when the groove part 215 does not correspond to the shape of the protection part 214, the groove part 215 may have any shape as long as it is a shape that can guide the flux flowing from the bonding part 213 to another area without penetrating into the protection part 214.

According to some embodiments, the groove part 215 may have a set or predetermined width w. For example, the width w of the groove part 215 may be a size in which the flux flowing from the bonding part 213 may be guided to flow along the groove part 215 without flowing into the gap G above the protection part 214. For example, the width w of the groove part 215 may be 0.5 mm or more. When the width w of the groove part 215 is less than 0.5 mm, the flux is not smoothly guided to the groove part 215, so that a relatively large amount of flux may flow into the gap G. The upper limit of the width w of the groove part 215 is not particularly limited, but may not be greater than the distance between the bonding part 213 and the protection part 214.

In addition, the groove part 215 may be formed on or in one surface of the circuit board 210 to have a set or predetermined depth d1. Before the depth d1 of the groove part 215 is described, first, examples of components of the circuit board 210 will be described.

As shown in FIG. 8, the circuit board 210 may include two or more metal layers 211 and one or more insulating layers 212. The insulating layer 212 may be alternately stacked with the metal layer 211. The circuit board 210 may have a stacked structure in which the metal layer 211 and the insulating layer 212 are alternately stacked.

The metal layer 211 does not need to be formed entirely of metal. That is, the metal layer 211 may be a layer in which a set or predetermined metal pattern is formed between insulating members. Hereinafter, the metal layer 211, may refer to the metal pattern included in the metal layer 211.

The metal layer 211 may be formed of a conductive material. For example, the conductive material may include a metal such as nickel (Ni), copper (Cu), and the like. For example, the metal layer 211 may serve as a metal wiring, a protection circuit device, and/or a terminal on the circuit board 210. For example, the protection circuit element may include one or more passive elements such as a resistor or a capacitor, or an active element such as a field effect transistor (FET). In addition, the metal layer 211 may serve as a temperature sensor, a fuse, and the like. For example, the temperature sensor may include a positive temperature coefficient thermistor, a negative temperature coefficient thermistor, and/or the like. For example, the fuse may disconnect the electrical flow to the secondary battery 100 by melting when an overcurrent occurs due to overcharging, overdischarging, an external short circuit, and/or the like.

The insulating layer 212 may be formed of a non-conductive material. For example, the non-conductive material may include epoxy resin, Bakelite resin, polyimide (PI), etc., as an insulator. Accordingly, the insulating layer 212 may electrically insulate the upper and lower metal layers 211.

A via hole formed through the metal layer 211 and/or the insulating layer 212 may be formed in the circuit board 210. All or part of the conductive components included in the metal layer 211 may be electrically connected to each other through the via hole.

As described above, the bonding part 213 and the protection part 214 are provided on the upper surface of the circuit board 210. In addition, the soldering layer SL may be further formed on the upper surface of the bonding part 213. In such examples, the bonding part 213 and the protection part 214 may correspond to parts of the metal layer 211. In addition, the bonding part 213 may be electrically connected to the circuit pattern of the metal layer 211. Hereinafter, an example in which the bonding part 213 and the protection part 214 are parts of the metal layer 211, that is, parts of a first metal layer 211a located at the uppermost side, will be further described.

The metal layer 211 composed of two or more layers may include the first metal layer 211a. The first metal layer 211a may form one surface of the circuit board 210. The first metal layer 211a may form one surface of the circuit board 210 facing the connection member 220. That is, the first metal layer 211a may be located closest to the connection member 220 on the circuit board 210. For example, the first metal layer 211a may be located on an uppermost side among the plurality of metal layers 211, and may form an upper surface of the circuit board 210.

In addition, the groove part 215 may be formed in a part of the first metal layer 211a. For example, the groove part 215 may be formed in a part of the protection part 214 of the first metal layer 211a. In such examples, as shown in FIG. 6, the groove part 215 may be located at an edge of the protection part 214 facing the bonding part 213. Accordingly, the groove part 215 may guide the flux flowing to the protection part 214 from the bonding part 213 to the groove part 215.

For example, the groove part 215 may have a shape surrounding a part of the protection part 214. For example, when the protection part 214 has a rectangular shape, the groove part 215 may have a substantially rectangular frame shape (e.g., a rectangle with a central rectangular cutout) with a set or predetermined width (which may be defined as the spacing between adjacent edges of the bonding part 213 and protection part 214). Because the groove part 215 has a shape surrounding the protection part 214, that is, the groove part 215 is also formed on the sides of the protection part 214 that do not face the bonding parts 213, the space of the groove part 215 may be increased as much as possible.

According to some embodiments, as shown in FIG. 6, a part 214a of the protection part 214 may be located inside the groove part 215, and the remaining part 214b of the protection part 214 may be located outside the groove part 215. In some examples, the entire protection part 214 may be located inside the groove part 215.

A part of the insulating layer 212 located closest to the first metal layer 211a, that is, the insulating layer 212 located at the uppermost side, may be exposed by the groove part 215. In such examples, the depth d1 of the groove part 215 may be substantially the same as the thickness of the first metal layer 211a.

As described above, the electrode tab 70 may be bonded to the connection member 220 in the second connection area 220b (see, e.g., FIG. 3). In such examples, the protection part 214 may prevent the circuit board 210 located thereunder from being damaged during the welding process of the electrode tab 70 and the connection member 220. In addition, by inducing the flow of flux to the groove part 215 formed in at least a part of the protection part 214, the flux may not flow into the gap G between the protection part 214 and the connection member 220 or the inflow thereof may be reduced.

Through this structure, even when the protection circuit module 200 is bonded to the secondary battery 100, a bonding defect may not occur. Also, the safety of the battery pack 1000 including the protection circuit module 200 and the secondary battery 100 may be enhanced.

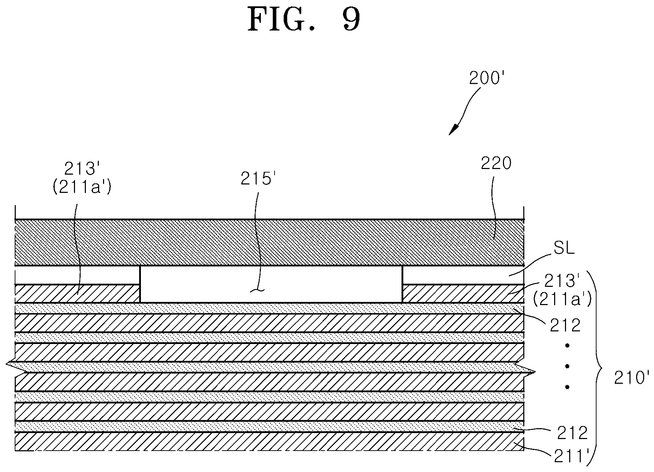

FIG. 9 is a cross-sectional view schematically showing a part of a configuration of a protection circuit module according to some other embodiments of the present disclosure.

Referring to FIG. 9, a protection circuit module 200' includes a circuit board 210' and a connection member 220. The circuit board 210' includes a plurality of metal layers 211' and at least one insulating layer 212. In addition, the circuit board 210' further includes a bonding part 213 formed on an upper surface thereof. In FIG. 9, only a partial configuration of the protection circuit module 200' is enlarged and shown.

Unlike the protection circuit module 200 of FIG. 8, the protection circuit module 200' does not have the protection part 214 (see, e.g., FIG. 8) between the pair of bonding parts 213. Accordingly, the bonding parts 213' may be on each of both sides of the second connection area 220b, and a groove part 215' may be formed in the entire space between the pair of bonding parts 213 on both sides.

Accordingly, the groove part 215' may be easily formed by a simple process. In addition, the groove part 215' is provided as a wider space between the connection member 220 and the circuit board 210' so that the flux may be guided more effectively to fill only a part of the space of the groove part 215'. Therefore, even when the flux generated during the welding of the connection member 220 and the electrode tab 70 flows into the groove part 215' from an upper side of the groove part 215', it is possible to suppress the occurrence of welding defects resulting from the flux.

The groove part 215' may be formed on or in one surface of the circuit board 210'. For example, the circuit board 210' may include two or more metal layers 211' and one or more insulating layers 212. The insulating layer 212 may be alternately stacked with the metal layer 211'. The circuit board 210' may have a stacked structure in which the metal layer 211' and the insulating layer 212 are alternately stacked.

The two or more metal layers 211' may include a first metal layer 211a'. The first metal layer 211a' may form one surface of the circuit board 210'. The first metal layer 211a' may form one surface facing the connection member 220. That is, the first metal layer 211a' may be located closest to the connection member 220 on the circuit board 210'. For example, the first metal layer 211a' may be located at the uppermost layer among the plurality of metal layers 211'. In addition, the bonding part 213' may be a part of the first metal layer 211a'. The bonding parts 213' may be provided as a pair spaced apart at a set or predetermined interval.

For example, as shown in FIG. 9, the groove part 215' may correspond to the entire space between the pair of bonding parts 213 spaced apart at a set or predetermined interval. Accordingly, the groove part 215' may have a larger space than the groove part 215 shown in FIG. 8. Through such a structure, even when the connection member 220 and the electrode tab 70 of the secondary battery 100 are bonded, a bonding defect of the protection circuit module 200' may not occur. Also, the safety of the battery pack 1000 including the protection circuit module 200' and the secondary battery 100 may be enhanced.

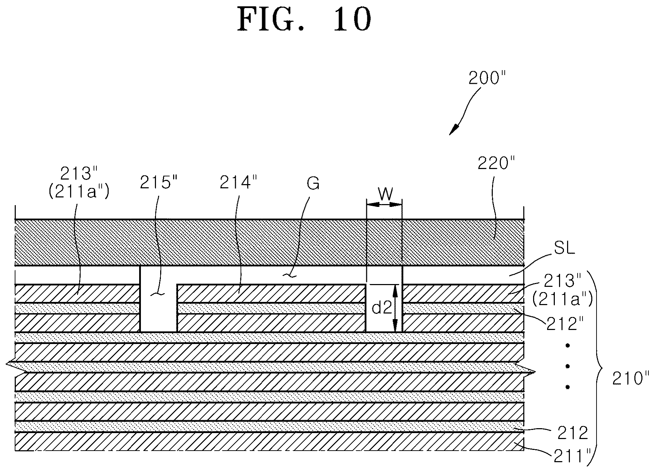

FIG. 10 is a cross-sectional view schematically showing a part of a configuration of a protection circuit module according to still other embodiments of the present disclosure.

Referring to FIG. 10, a protection circuit module 200" includes a circuit board 210" and a connection member 220. The circuit board 210" includes a plurality of metal layers 211" and at least one insulating layer 212. In addition, the circuit board 210" may further include a bonding part 213" and a protection part 214" formed on an upper surface thereof. In FIG. 10, only a partial configuration of the protection circuit module 200" is enlarged and shown for ease of illustration.

Similar to the FIG. 8, the protection circuit module 200" according to some embodiments may be provided with the protection part 214" between a pair of bonding parts 213". That is, a groove part 215" may be formed between the bonding part 213" and the protection part 214". However, a depth d2 of the groove part 215" may be deeper than the depth d1 of the groove part 215 of FIG. 8.

For example, the groove part 215" may be formed in a part of an upper surface of the circuit board 210". In addition, the groove part 215" may be formed deeper than the groove part 215 of FIG. 8 in a peripheral area of the protection part 214", and at least between the bonding parts 213. The groove part 215" may provide a path for guiding the flow of flux generated during a welding process between the connection member 220 and the electrode tab 70 from an upper side of the protection part 214.

As a result, the flux may not flow into a gap G between the protection part 214" and the connection member 220. In addition, the groove part 215", which has a greater depth than the groove part 215, may more effectively separate the bonding part 213" and the protection part 214". Accordingly, it is possible to prevent or substantially reduce the occurrence of bonding defects during the welding process between the connection member 220 and the electrode tab 70. In addition, the protection part 214" may serve as a buffer to prevent the circuit board 210" from being damaged during the welding of the connection member 220 and the electrode tab 70.

For example, the groove part 215" may be formed at an edge of the protection part 214 facing the bonding part 213" to form a step with the bonding part 213" and the protection part 214. In addition, the groove part 215" may have a set or predetermined width w. In addition, the groove part 215" may be formed on or in one surface of the circuit board 210" to have the set or predetermined depth d2. Before the depth d2 of the groove part 215" is described, first, examples of components of the circuit board 210" will be described.

For example, the circuit board 210" may include two or more metal layers 211" and one or more insulating layers 212. The insulating layer 212 may be alternately stacked with the metal layer 211". The circuit board 210 may have a stacked structure in which the metal layer 211" and the insulating layer 212 are alternately stacked.

The metal layer 211" may be formed of a conductive material. For example, the conductive material may include a metal such as nickel (Ni), copper (Cu), and the like. For example, the metal layer 211" may serve as a metal wiring, a protection circuit device, and/or a terminal on the circuit board 210". For example, the protection circuit element may include one or more passive elements such as a resistor or a capacitor, or an active element such as a field effect transistor (FET). In addition, the metal layer 211" may serve as a temperature sensor, a fuse, and/or the like. For example, the temperature sensor may include a positive temperature coefficient thermistor, a negative temperature coefficient thermistor, and/or the like. For example, the fuse may disconnect the electrical flow to the secondary battery 100 by melting when an overcurrent occurs due to overcharging, overdischarging, an external short circuit, and/or the like.

The insulating layer 212 may include a non-conductive material. For example, the non-conductive material may include epoxy resin, Bakelite resin, polyimide (PI), etc., as an insulator. Accordingly, the insulating layer 212 allows the upper and lower metal layers 211" to be insulated from each other.

A via hole formed through the metal layer 211" and/or the insulating layer 212 may be formed in the circuit board 210". All or part of the conductive components included in the metal layer 211" may be electrically connected to each other through the via hole.

The upper surface of the circuit board 210" is provided with the bonding part 213" and the protection part 214". In addition, a soldering layer SL may be formed on an upper surface of the bonding part 213". As described above, the bonding part 213" and the protection part 214" may correspond to parts of the metal layer 211". In addition, the bonding part 213" may be electrically connected to the metal layer 211". Hereinafter, an example in which the bonding part 213" and the protection part 214" are parts of the metal layer 211", that is, parts of a first metal layer 211a" will be further described.

The two or more metal layers 211" may include the first metal layer 211a". The first metal layer 211a" may form one surface of the circuit board 210". The first metal layer 211a" may form one surface facing the connection member 220. That is, the first metal layer 211a" may be located closest to the connection member 220 on the circuit board 210". For example, the first metal layer 211a" may be located at the uppermost layer among the plurality of metal layers 211".

In addition, the groove part 215" may be formed in a part of the first metal layer 211a". For example, the groove part 215" may be formed in a part of the protection part 214" of the first metal layer 211a". In such examples, the groove part 215" may be located at an edge of the protection portion 214" facing the bonding part 213. Accordingly, the groove part 215" may guide the flux flowing to the protection part 214" from the bonding part 213" to the groove part 215".

In addition, the depth d2 of the groove part 215" may be deeper than the depth d1 of the groove part 215 of FIG. 8. For example, a part of the insulating layer located below the uppermost insulating layer 212", such as the second uppermost insulating layer 212, may be exposed by the groove part 215". However, this is only an example, and a part of the third uppermost insulating layer 212 or the insulating layer 212 located below may also be exposed by the groove part 215".

As shown in FIG. 10, the electrode tab 70 may be bonded to the connection member 220. In such examples, the protection part 214" may prevent the circuit board 210" from being damaged during the welding process. In addition, by guiding the flow of flux, the groove part 215" may prevent the flux from entering the gap G between the protection part 214" and the connection member 220. Because the depth d2 of the groove part 215" is deeper than the depth d1 of the groove part 215 of FIG. 8, the flux may be better guided to more effectively prevent (e.g., block) the flux from flowing into the gap G between the protection part 214" and the connection member 220.

Through this structure, even when the protection circuit module 200" is bonded to the secondary battery 100, a bonding defect may not occur. Also, the safety of the battery pack 1000 including the protection circuit module 200" and the secondary battery 100 may be enhanced.

According to some embodiments of the present disclosure, it is possible to prevent welding defects when welding a protection circuit module and a secondary battery by allowing the flux to flow to a groove part.

According to some embodiments of the present disclosure, the safety and lifetime of a protection circuit module and a battery pack including the protection circuit module can be improved.

It should be understood that embodiments described herein should be considered in a descriptive sense and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A protection circuit module (200, 200', 200") comprising:
a connection member (220) comprising a first connection area (220a) and a second connection area (220b); and
a circuit board (210, 210', 210") comprising, on one surface facing the connection member, a bonding part (213) that is soldered in the first connection area (220a) of the connection member and a groove part (215, 215') that is formed to have a step with the one surface at a location corresponding to a gap between the first connection area (220a) and the second connection area (220b).

2. The protection circuit module (200, 200") of claim 1, wherein the circuit board (210, 210") further comprises a protection part (214) provided at a location corresponding to the second connection area (220b), and
wherein the groove part (215, 215") is formed between the bonding part (213) and the protection part (214).

3. The protection circuit module of claim 2, wherein the bonding part (213) is on each of both sides of the protection part (214), and
wherein the groove part (215, 215") is formed to surround an edge of the protection part (214) adjacent to the bonding part (213).

4. The protection circuit module of claim 3, wherein the groove part (215, 215") has a width (w) of 0.5 mm or more.

5. The protection circuit module of any one of claims 2 to 4, wherein the circuit board (210, 210") further comprises a plurality of metal layers (211, 211") and one or more insulating layers (212) between the plurality of metal layers that are adjacent to each other, and
wherein the bonding part (213) and the protection part (214) are parts of a first metal layer (211a, 211a") of the plurality of metal layers (211, 211") that is closest to the connection member (220).

6. The protection circuit module of claim 5, wherein the groove part (215, 215") has a depth (d1, d2) that exposes one surface of one insulating layer of the one or more insulating layers (212).

7. The protection circuit module of claim 6, wherein the groove part (215) has a depth (d1) that exposes one surface of an insulating layer of the one or more insulating layers (212) that is in contact with the first metal layer (211a).

8. The protection circuit module (200') of claim 1, wherein the bonding part (213) is on each of both sides of the second connection area (220b), and
wherein the groove part (215') is formed in an entire space between the bonding parts (213) on both sides.

9. The protection circuit module (200, 200', 200") of any one of claims 1 to 8, wherein the protection circuit module is electrically connected to one or more secondary batteries (100), and
wherein the connection member (220) is bonded to an electrode tab (70) of each secondary battery (100) in the second connection area (220b).

10. The protection circuit module of claim 9, wherein the connection member (220) comprises:
a lower plate (221) located between the circuit board (210) and the electrode tab (70);
an upper plate (222) located above the lower plate (221) with the electrode tab (70) therebetween; and
a hinge portion (223) connecting one side of the lower plate (221) and one side of the upper plate (222).

11. The protection circuit module of claim 10, wherein the upper plate (222), the electrode tab (70), and the lower plate (221) are bonded by welding in the second connection area (220b).

12. A battery pack (1000) comprising:
one or more secondary batteries (100) comprising an electrode tab (70) extending outward; and
a protection circuit module (200, 200', 200") according to any one of claims 1 to 11 that is electrically connected to the electrode tab of each secondary battery (100).
